Europäisches Patentamt

European Patent Office

Office européen des brevets

(19)

(11) Publication number: **0 198 660**
**A1**

# EUROPEAN PATENT APPLICATION

(21) Application number: 86302623.3

(22) Date of filing: 09.04.86

(51) Int. Cl.⁴: **C 03 C 27/00**

(30) Priority: **17.04.85 US 724329**

(43) Date of publication of application: **22.10.86**
**Bulletin 86/43**

(84) Designated Contracting States: **AT BE CH DE FR GB IT LI
LU NL SE**

(71) Applicant: **JOHNSON MATTHEY, INC.,, 4 Malin Road,
Malvern Pennsylvania 19355 (US)**

(72) Inventor: **Dietz, Raymond L., 16121 Del Norte, Poway
California 92064 (US)**
Inventor: **Salazar, Romeo, 2248 Spring Oak Way, San
Diego California 92139 (US)**
Inventor: **Wiese, Frederick, 11444 Duenda Road, San
Diego California 92127 (US)**

(74) Representative: **Arthur, Bryan Edward, Withers &
Rogers 4 Dyer's Buildings Holborn, London EC1N 2JT
(GB)**

(54) **Silver-filled glass metallizing pastes.**

(57) The present invention relates to silver filled glass metallizing pastes (14) which are particularly suitable for bonding semiconductive devices (12) to ceramic substrates (10). More specifically, the silver-filled glass metallizing paste suitable for bonding semiconductor devices to ceramic substrates consists essentially of in percentages by weight:

(a) 25 to 95% silver flake having a surface area of at least about 0.2 m²/g and an average tap density in the range of 3.2 to 4.0 g/cm³; said paste being characterized by less shrinkage and fillet cracking when fired in the bonding of a semiconductive device to a ceramix substrate than a corresponding paste based on silver particulate having a tap density in the range of 2.2 to 2.8 g/cm³;

(b) 75 to 5% of a substantially sodium-free high lead borate glass frit having a softening temperature below 425°C, a coefficient of thermal efficiency no higher than about 13 ppm/°C, a surface area of at least about 0.3 m²/g and a tap density of up to 3.6 g/cm³; and

(c) a liquid organic vehicle in an amount sufficient to provide a percent solids in the paste of about 75 to 85%.

1

## SILVER-FILLED GLASS METALLIZING PASTES

The present invention relates to silver-filled glass metallizing pastes which are particularly suitable for bonding semiconductive devices to ceramic substrates.

### Background of the Invention

The above mentioned applications and patents describe and claim silver-filled glass compositions ("pastes") which are suitable for bonding silicon semiconductive devices to ceramic substrates. These pastes have made it possible to effectively replace the use of more expensive gold-based bonding compositions. However, notwithstanding the advantages of the silver-based compositions exemplified in said above mentioned patents and applications, it is still desirable to have compositions which will provide even further improvements in performance.

### Objects of the Invention

An important object of the invention is to provide novel silver-filled paste compositions of the type referred to above which offer certain specific advantages over the pastes specifically described in said earlier applications and patents. A particular feature of a preferred group of pastes according to the invention is that they can be used at significantly lower firing temperatures than the pastes specifically exemplified in the earlier patents and applications.

2

Another object of the invention is to more adequately define the generic concepts represented by the earlier described pastes, based on disclosure common to the present application and to one or more of the earlier filings. Other objects will also be hereinafter apparent.

Brief Description of the Invention

The pastes of the invention may be broadly described as consisting essentially of:

25 to 95% silver particulate having a surface area of at least about 0.2 $m^2$/gm, preferably 0.2 to 1.0 $m^2$/gm, and a tap density of at least about 2.2 gm/cc;

75 to 5% of a substantially sodium-free glass frit, preferably a high lead borate glass frit, having a softening temperature below 425°C, preferably in the range of 325°C to 425°C, a coefficient of thermal expansion no higher than about 13 ppm/°C, a surface area of at least about 0.3 $m^2$/gm, and a tap density of up to 3.6 gm/cc; and

a liquid organic vehicle in an amount sufficient to provide a percent solids in the paste of about 75 to 85%.

The invention contemplates two specifically novel and preferred types of pastes, within the broad category defined above, which offer certain special and unobvious advantages. The first of these preferred embodiments comprises a silver-filled paste of the type indicated wherein the silver component is silver flake having an average tap density of at least 3 gm/cc, preferably in the range of 3.2 to 4.0 gm/cc. It has been found that the use of silver flake having this higher tap density than specifically exemplified in the earlier patents and applications mentioned above provides a paste which results in less shrinkage and fillet cracking when the paste is used than corresponding pastes based on silver flake having a tap density significantly below 3 gm/cc, e.g. 2.8 gm/cc.

The other separately novel and particularly preferred embodiment of the invention comprises a "low temperature" composition, i.e. a paste which can be effectively used to give better adhesion using lower firing temperature than hitherto possible. Normally, when using the pastes specifically described in the above mentioned patents and applications, it has been considered necessary or desirable to use firing temperatures in the order of in excess of about 410°C or so, in order to obtain the best adhesion between the semiconductor die and the cermaic substrate. While this sort of firing temperature is satisfactory for most uses, there are certain applications, particularly in the processing of multilayer packages or components, for example, said braze, chip carrier, pin grid arrays and the like, where lower firing temperatures, giving the desired degree of adhesion would be particularly advantageous. For example, the indicated multilayer packages, as opposed to the "Cerdip" type of device, include a nickel and gold-plated metallized seal ring for subsequent sealing with gold/tin preforms. A high firing temperature (e.g. 425°C or more) in air may drive the underlying plated nickel through the gold plating and cause the nickel to oxidize thus making it difficult for the gold/tin preform to wet and effect the desired hermetic sealing. The low temperature compositions of the invention make it possible to effectively use significantly lower firing temperature, e.g. temperatures in the order of about 370°C to about 310°C, and preferably about 370-375°C, with elimination of the disadvantages resulting from the use of higher firing temperature, while providing a degree of adhesion equivalent to those obtained at higher firing temperatures. As a consequence, the present low temperature pastes can be used for those applications, e.g. the processing of multilayer devices, where higher temperatures might cause the disadvantages noted above.

The low temperature composition of the invention is based on the unexpected finding that the glass softening temperature, silver flake tap density and surface area are interrelated and can have an important and desirable effect on the adhesion obtained and that by the proper selection of the glass and silver flake so as to meet certain critical limits for those three conditions, it is possible to effectively reduce the firing temperature while obtaining the desired degree of adhesion. In particular, it has been found that pastes based on the use of glass frit which has a softening point in the range of about 320-350°C and silver flake having a tap density of 2.5 - 3.6 gm/cc and a surface area of 0.7 - 0.9 $m^2$/gm, can be employed in the assembly of multilayer packages at firing temperatures in the order of about 370°C to about 390°C, and about 370-375°C without the disadvantages encountered when operating with other generally similar pastes requiring higher firing temperatures. Advantageously, for this purpose, the

5

glass frit also has a surface area of about 1.0 to 2.5 m$^2$/gm and a tap density of about 2.0 to 3.5 gm/cc although this is not essential provided the glass meets the indication softening point requirement.

## THE DRAWINGS

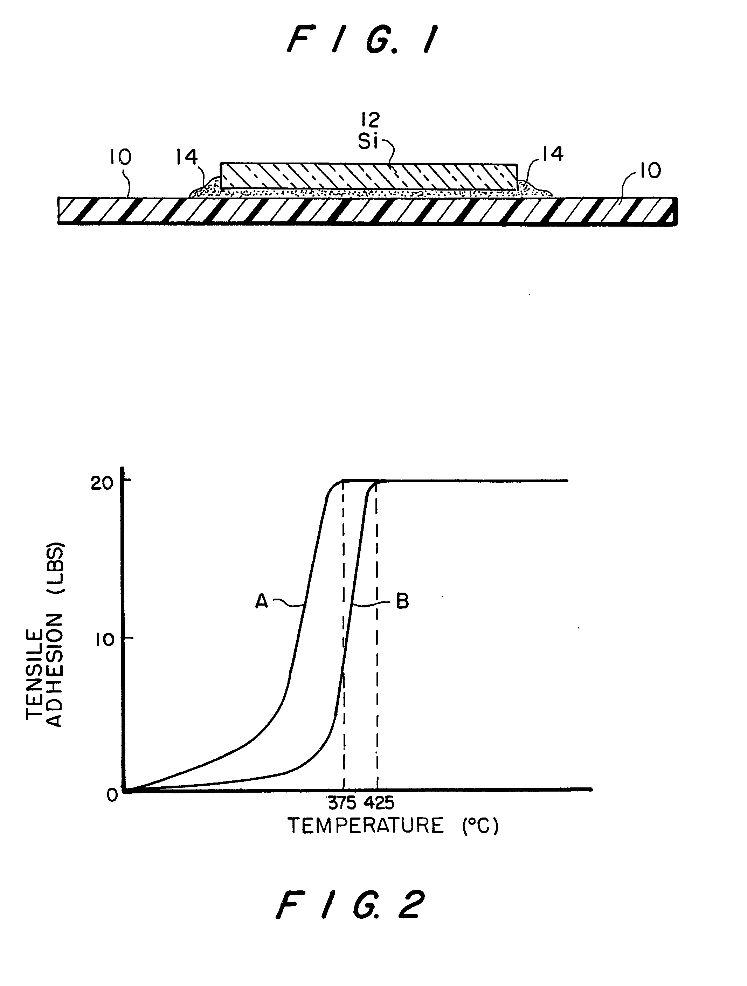

Figure 1 of the accompanying drawings illustrates the manner in which the present pastes may be used for bonding purposes. As shown, the paste (14) is employed to bond a semiconductor, e.g. a silicon die (12) to a ceramic substrate (10).

Figure 2 is a graph which diagrammatically illustrates typical adhesion/firing temperature curves for the low temperature paste of the invention (Curve A) and for a generally similar paste where the glass utilized had a somewhat higher softening temperature and the silver flake did not meet the tap density and surface area limits required for low temperature firing (Curve B).

## Detailed Description of the Invention

For the broader aspects of the invention, the silver flake or other powder form, disclosed in the earlier patens and applications may be used to make useful pastes. The tap density of the silver powder disclosed in the earlier filings was at least about 2.2 gm/cc, with a tap density of about 2.2 to 2.8 gm/cc being specifically disclosed. Such powder may be effectively used herein; however, in accordance with one of the preferred embodiments, it has been found that significantly better results can be obtained using silver flake with a higher tap density than earlier disclosed, i.e. a tap density of at least 3.0 gm/cc, and preferably 3.2 to 4.0 gm/cc. Advantageously, the silver flake has a surface area of 0.2 to 1.0 $m^2$/gm and the glass frit is such that it has a softening point in the range 25 to 325 to 380°C, a coefficient of thermal expansion in the range of 10-13 ppm/°C, a surface area of 1.6 -2.5 $m^2$/gm and a tap density in the region of about 2.0 - 3.5 gm/cc except that, in the case of the low temperature pastes, specifically different limits must be observed for the glass softening temperature, silver tap density and surface area.

The glass frit component may be any of those disclosed in our earlier patents or applications, in the broadest aspect of the invention. Thus, for example, the indicated U.S. patents specifically exemplify the use of high-lead borosilicate glass frit which is substantially free of sodium having the softening temperature, coefficient of thermal expansion, surface area and tap density referred to above in the broad definition of the present pastes. In S.N. 608,479, we have also disclosed the use of high-lead borate glass frit which is substantially free of silica as well as sodium. Such glass may also be used herein. Preferably, however, at least in accordance with the low temperature embodiment of this invention, the glass used is one which has a softening temperature of about 320-350°C, a surface area of about 1.5 - 2.5 $m^2$/gm and a tap density of about 2.0 - 3.5 gm/cc. The silver used with such glass is silver flake having a tap density of 2.5 - 3.6 gm/cc and a surface area of 0.7 - 0.9 $m^2$/gm.

The glass is made into frit suitable for use herein as described in our earlier filings. Any glass, particularly high-lead borate, sodium free glass which has the indicated properties may be used for present purposes. Preferably, however, the glass consists essentially of PbO and $B_2O_3$, usually in the range of 70-95% PbO and 30-5% $B_2O_3$. A particularly useful glass comprises 78% PbO and 22% $B_2O_3$.

The liquid organic vehicle employed is one which is inert and permits easy formulating and application. The vehicle should also be readily volatilized and/or burnt off without leaving any undesired residue. It is particularly useful to use a vehicle which comprises a small amount of a thermoplastic polymer, e.g. an acrylate or methacrylate polymer, dissolved in an aliphatic hydrocarbon or alcohol. Suitable liquid vehicles include those disclosed in our above mentioned earlier filings. This includes a combination of ethyl methacrylate, actually poly (ethyl methacrylate), and terpineol. Preferably, however, the vehicle comprises a mixture of the poly (ethyl methacrylate) or like polymer or resin in texanol, the latter being 2,2,4-trimethyl-1,3-pentane diol-monoisobutyrate. Normally the polymer or resin will comprise 5-15% by weight of the vehicle with the solvent, e.g. terpineol or texanol, making up the balance of the paste vehicle.

The pastes of the invention are prepared and used essentially as described in our above mentioned earlier filings. A typical use of the present paste will be the bonding means employed in preparing electrical circuit modules according to U.S. patent 3,497,774 although it will be recognized by those in the art that a variety of other uses are also contemplated.

The invention is further described by reference to the following examples:

## Example 1

This example illustrates the low temperature paste of the invention.

Silver flake having a tap density of 2.96 gm/cc and a surface area of 0.8 $m^2$/gm; and glass frit (78% PbO and 22% $B_2O_3$) having a softening point of 330°C, a surface area of 1.2 $m^2$/gm, a tap density of 2.2 gm/cc, and a coefficient of thermal expansion of 11.3 ppm/°C, were added to a vehicle comprising polyethyl methacrylate and texanol in amounts such as to provide a paste containing, on a weight basis, 66.4% silver flake, 16.6% glass; balance vehicle containing about 10% polyethyl methacrylate. The paste has a viscosity of about 20 kcps, as measured on a Brookfield RVT viscometer, with a TC spindle, at 10 RPM and 25°C.

When used to bond a semiconductor die to an appropriate metallized multilayer ceramic substrate, namely, a pin grid array, it was found that the paste gave an adhesion of greater than 20 pounds tensile at a peak firing temperature of 375°C. This compares favorably to an adhesion of 8 pounds tensile generated with a corresponding paste using silver flake having a surface area of 0.3 - 0.5 $m^2$/gm and a tap density of 3.0 - 4.0 gm/cc when fired at the same temperature. Both pastes gave adhesions greater than 20 pounds when fired at 425°C.

9

Figure 2 schematically compares the adhesion/temperature curves for the paste of this invention (Curve A) and for a generally similar paste (Curve B) based on the use of a glass frit having a higher softening point (370°C). It will be noted that Curve A levels off at the desired adhesion at a lower temperature than the paste based on the higher softening point glass.

## EXAMPLE 2

This example illustrates the other preferred embodiment of the invention using high tap density silver flake.

A paste was prepared from silver flake having a tap density of 3.41 gm/cc and a surface area of .032 $m^2$/gm; glass frit (78% PbO and 22% $B_2O_3$) having a surface area of 2.42 $m^2$/gm, a tap density of 1.96 gm/cc, a coefficient of thermal efficiency of 10.8 ppm/°C and a softening point of 360°C; and the vehicle used in Example 1. The paste had a composition of 68.8% flake, 17.2% glass, balance vehicle including about 10% polyethyl methacrylate. The composition gave excellent die adhesion using a firing temperature of 425°C.

Various modification may be made in the invention as described above. Accordingly, the scope of the invention is defined in the following claims wherein:

CLAIMS:

1. A silver-filled glass metallizing paste suitable for bonding semiconductor devices to ceramic substrates consisting essentially of in percentages by weight:

a) 25 to 95% silver flake having a surface area of at least about 0.2 m²/gm and an average tap density in the range of 3.2 to 4.0 gm/cc; said paste being characterized by less shrinkage and fillet cracking when fired in the bonding of a semiconductive device to a ceramic substrate than a corresponding paste based on silver particulate having a tap density in the range of 2.2 to 2.8 gm/cc;

b) 75 to 5% of a substantially sodium-free high lead borate glass frit having a softening temperature below 425°C, a coefficient of thermal efficiency no higher than about 13 ppm/°C, a surface area of at least about 0.3 m²/gm and a tap density of up to 3.6 gm/cc; and

c) a liquid organic vehicle in an amount sufficient to provide a percent solids in the paste of about 75 to 85%.

2. A silver-filled glass metallizing paste suitable for bonding semiconductor devices to ceramic substrates consisting essentially of in percentages by weight:

a) 25 to 95% silver flake;

b) 75 to 5% of a frit; and

c) a liquid organic vehicle in an amount sufficient to provide a percent solids in the paste of about 75 to 85%, said paste being characterized by providing effective adhesion between semiconductive device and substrate, at firing temperatures in the range of 370-390°C, wherein the silver flake has a tap density of 2.5 - 3.6 gm/cc and a surface area of 0.7 - 0.9 m²/gm and the glass frit has a softening point in the range of 320-350°C, a surface area in the range of about 1.0 to 2.5 m²/gm and a tap density of about 2.0 to 3.5 gm/cc.

1 / 1

# F I G. I

# F I G. 2

**European Patent Office**

**EUROPEAN SEARCH REPORT**

Application number

| Category | Citation of document with indication, where appropriate, of relevant passages | Relevant to claim | CLASSIFICATION OF THE APPLICATION (Int. Cl.4) |
|---|---|---|---|
| X | GB - A - 2 104 058 (AVX CORPORA-TION)  * Page 1, lines 3-7,66-117 * | 2 | C 03 C 27/00 |
| A | | 1 | |

**DOCUMENTS CONSIDERED TO BE RELEVANT** — EP 86302623.3

TECHNICAL FIELDS SEARCHED (Int. Cl.4)

C 03 C

H 05 B

H 01 B

H·01 C

H 05 K

H 01 L

C 04 B

C 23 C

The present search report has been drawn up for all claims

| Place of search | Date of completion of the search | Examiner |
|---|---|---|
| VIENNA | 08-07-1986 | HAUSWIRTH |

CATEGORY OF CITED DOCUMENTS.

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82